(19) **Europäisches Patentamt**

**European Patent Office**

**Office européen des brevets**

(11) **EP 1 450 173 A2**

(12) **EUROPÄISCHE PATENTANMELDUNG**

(43) Veröffentlichungstag:
25.08.2004  Patentblatt 2004/35

(51) Int Cl.7: **G01R 31/36**, H01M 10/48

(21) Anmeldenummer: **04003368.0**

(22) Anmeldetag: **16.02.2004**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **24.02.2003  US 449811 P**

(71) Anmelder: **DaimlerChrysler AG**
**70567 Stuttgart (DE)**

(72) Erfinder:
• **Bitsche, Otmar**
**70329 Stuttgart (DE)**
• **Spier, Bernd, Dr.**
**88483 Burgrieden (DE)**
• **Ashtiani, Cyrus**
**West Bloomfield, Michigan, 48323 (US)**
• **Lagerstrom, Rick**
**Femdale, MI, 48220 (US)**

(54) **Verfahren zur Ermittlung der Alterung einer Batterie**

(57)  Gemäß der Erfindung werden zur Ermittlung der Alterung einer Batterie die Lade- und Entladezyklen der Batterie nach Anzahl und Tiefe der Ladung/Entladung erfasst. Für jeden der Lade- und Entladezyklen wird anhand einer für den jeweiligen Batterietyp charakteristischen Alterungskennlinie ein Alterungskennwert ermittelt. Diese einzelnen Alterungskennwerte werden dann zur Alterung der Batterie aufsummiert.

EP 1 450 173 A2

**Beschreibung**

Technisches Gebiet der Erfindung

Die Erfindung liegt auf dem technischen Gebiet der Zustandsüberwachung von Batterien. Insbesondere betrifft sie ein Verfahren zur Ermittlung der Alterung einer Batterie, wobei Lade- und Entladezyklen der Batterie nach Anzahl und Tiefe der Ladung/Entladung erfasst werden.

Hintergrund der Erfindung

Für Blei-, Nickelmetallhydrid- oder Lithium-Ionen-Batterien ist eine Überwachung der Alterung der Batterie, und damit letztendlich der Batterielebensdauer, zum Funktionserhalt von großer Bedeutung. Die Alterung bzw. Batterielebensdauer entspricht im allgemeinen der sogenannten Zyklenlebensdauer. Diese gibt an, wie viele Lade- und Entladezyklen bei einer Batterie möglich sind, bevor diese ihre Funktion einstellt. Für diese Zyklenlebensdauer ist neben der reinen Anzahl der Zyklen auch die Art der jeweiligen Zyklen, und hier insbesondere die Tiefe mit welcher die Batterie entladen bzw. auf welche Sie wieder aufgeladen wird, von Bedeutung. So besitzt beispielsweise eine Batterie bei 100 % Entladetiefe je Zyklus im statistischen Mittel eine Zyklenlebensdauer von 80 Zyklen, bei 1 % Entladetiefe je Zyklus dagegen eine Zyklenlebensdauer von 30 000 Zyklen. Das heißt es existiert zu jeder Lade-/Entladetiefe eine Zyklenzahl, die äquivalent zur Lebensdauer der Batterie ist. Die Gesamtlebensdauer der Batterie wird z. B. bei 200 000 Zyklen mit 0,75% Lade-/Entladetiefe (Depth of Discharge/DOD) oder bei 20 000 Zyklen mit 2,5% DOD; usw. erreicht.

Von den drei eingangs genannten Batteriesystemen hat die Bleibatterie die kürzeste Zyklenlebensdauer und die geringsten Beschaffungskosten. Deshalb besteht hier der größte Bedarf für eine geeignete Überwachung bzw. Prognose der Restzyklenlebensdauer.

Auf der Basis dieses Wissens, schlägt die DE 198 49 163 A1 einen integrierten Speicher in Batterien und Akkus in der Art vor, dass durch diesen für die Lebensdauer der Batterien interessante Daten gespeichert und ausgewertet werden. Leider lässt die oben genannte Schrift keinerlei Rückschlüsse auf die eigentliche Funktionsweise und insbesondere nicht auf die Auswertung der gespeicherten Daten zu, so dass hier keine für den Fachmann durchführbare Lehre entsteht, anhand der ein Verfahren zur Ermittlung der Alterung einer Batterie realisierbar wäre.

In der US 5,739,670 ist ein Verfahren zur Diagnose des Zustands von Batterien vorgeschlagen. Über entsprechende Zähler werden Ladezyklen und Lademengen sowie die zeitliche Dauer von Lade- und Entladevorgängen erfasst und gezählt. Die so ermittelten Werte werden über einen entsprechend komplexen Zusammenhang mittels einer e-Funktion so modifiziert, dass daraus eine Berechnung des allgemeinen Zustands der Batterie erfolgen kann.

Die Vorgehensweise ist vergleichsweise aufwändig, da entsprechend viele Daten gewonnen und in komplexer Form miteinander verrechnet werden müssen, um die vergleichsweise wagen Aussagen über den allgemeinen Zustand der Batterie treffen zu können.

Eine weitere Möglichkeit, die Alterung bzw. den Alterungszustand einer Batterie zu bestimmen, liegt in einer aktiven Diagnose. Bei dieser aktiven Diagnose wird die Batterie mit einer vorgegebenen Kapazität be- oder entladen. Anhand einer Vermessung dieses aktiven Be- oder Entladevorgangs lassen sich dann über die entsprechenden Zusammenhänge, welche für den jeweiligen Vorgang bekannt sind, Rückschlüsse auf die Alterung der Batterie ziehen. Ein derartiges aktives Diagnoseverfahren ist beispielhaft in der EP 1 278 072 A1 beschrieben.

Darstellung der Erfindung

Ausgehend von dem oben genannten Gebiet der Erfindung und den dort erwähnten Nachteilen der bisher üblichen Lösungen gemäß dem Stand der Technik ist es nun die Aufgabe der hier vorliegenden Erfindung, ein Verfahren zur Ermittlung der Alterung einer Batterie anzugeben, welches eine sichere und zuverlässige Bestimmung der Alterung der Batterie, insbesondere auch bei Anwendungen mit in der Ladung und Entladung sehr stark variierenden Zyklen, ermöglicht. Außerdem soll es auf dieser Basis möglich sein, eine Alterungsanzeige für die Batterie zu realisieren.

Gemäß der Erfindung wird diese Aufgabe dadurch gelöst, dass bei einem Verfahren zur Ermittlung der Alterung einer Batterie die Lade- und Entladezyklen der Batterie nach Anzahl und Tiefe der Ladung/Entladung erfasst werden. Für jeden der Lade- und Entladezyklen wird anhand einer für den jeweiligen Batterietyp charakteristischen Alterungskennlinie ein Alterungskennwert ermittelt. Diese einzelnen Alterungskennwerte werden dann zur Alterung der Batterie aufsummiert.

Für jeden Batterietyp, beispielsweise für einen Bleiakkumulator, eine Nickelmetallhydrid-Batterie oder eine Lithium-Ionen-Batterie lässt sich ein Zusammenhang zwischen der Entladetiefe und der Zyklenlebensdauer ermitteln. Aus diesem, zumindest im statistischen Mittel für den jeweiligen Batterietyp charakteristischen Zusammenhang lässt sich dann ein Diagramm errechnen, welches eine wiederum für den jeweiligen Batterietyp charakteristisches Alterungskennlinie aufweist. Diese Alterungskennlinie kann beispielsweise in Form von Prozentangaben als Funktion der Tiefe der Lade- bzw. Entladezyklen dargestellt werden. Für jeden Lade- bzw. Entladezyklus ergibt sich nun anhand seiner Lade- bzw. Entladetiefe aus dieser Kennlinie ein charakteristischer Alterungskennwert. Dieser Alterungskennwert wird dann allen bei vorherigen Zyklen bereits ermittelten Alterungskennwerten hinzuaddiert, so dass sich die Summe der Alterungskennwerte über die Lebensdauer der Batterie ständig erhöht. Durch den unmittelbaren Zusammenhang des Alterungskennwerts und der Lade- bzw. Entladetiefe des jeweiligen Zyklus durch die Alterungskennlinie ist dieser Wert der Lade- bzw. Entladetiefe, welcher maßgebend an der Alterung bzw. Lebensdauer der Batterie Anteil hat, schnell und einfach berücksichtigt.

Anstatt komplizierter Berechnungen ist für das Erfassen der Alterung der Batterie dann lediglich die Betrachtung der aktuellen Summe der Alterungskennwerte notwendig, um die Alterung der Batterie zu bestimmen. Die Summe der Alterungskennwerte wird sich über die Lebensdauer der Batterie einem Wert annähern, welcher für eine vollkommen verbrauchte Batterie steht. Bei einer prozentualen Angabe der einzelnen Alterungskennwerte wird diese Summe dann, im Falle der verbrauchten Batterie, 100 % sein.

Durch eine einfache Aufsummierung und Betrachtung der Summe lässt sich also zu jedem beliebigen Zeitpunkt bestimmen bzw. ablesen, wie stark die betroffene Batterie bereits gealtert ist und wie viel Restlebensdauer ihr verbleibt. Die Darstellung des Alterungskennwert, z.B. in Prozent der bereits verbrauchten Lebensdauer der Batterie, eignet sich ideal für eine einfache und effiziente Alterungsanzeige der Batterie.

In einer besonders günstigen Ausführungsform des erfindungsgemäßen Verfahrens wird jeder Teilzyklus der Ladung und jeder Teilzyklus der Entladung getrennt erfasst. Für jeden der Teilzyklen wird der Alterungskennwert ermittelt und die Alterungskennwerte für alle Teilzyklen werden gemeinsam aufsummiert.

Diese Ausgestaltung des erfindungsgemäßen Verfahrens ist insbesondere dann von Vorteil, wenn die Batterie nicht mit regelmäßigen Zyklen betrieben wird. Werden beispielsweise einzelne Zyklen der Entladung hintereinander geschaltet, ohne dass dazwischen wieder eine Vollladung auf den Ausgangswert der Entladezyklen erfolgt, so ist eine zyklenweise Betrachtungsweise vergleichsweise ungenau, da sie dieses Verhalten nicht abbilden kann.

Insbesondere bei hochbeanspruchten Batterien, wie sie beispielsweise zur Bereitstellung von elektrischer Energie für Traktionszwecken in Kraftfahrzeugen eingesetzt werden, spielen jedoch genau diese Lade- und Entladevorgänge eine besondere Rolle, da hier bei Energiebedarf entladen und bei vorhandener Energie entsprechend nachgeladen wird, ohne dass sich das Kraftfahrzeug an die jeweiligen Anforderungen der Batterien für die ideale Lebensdauer hält.

Um die Alterung einer Batterie unter diesen komplexen Betriebsbedingungen dennoch schnell, sicher und einfach ermitteln zu können, wird ein Zyklus gemäß der oben genannten Ausgestaltung der Erfindung in vorteilhafter Weise so definiert, dass er aus mehreren Teilzyklen besteht, welche jeweils unterschiedliche Lade- bzw. Entladetiefen repräsentieren. Üblicherweise würde es sich bei den Teilzyklen um zwei Halbzyklen handeln, nämlich einem ersten Halbzyklus der Entladung, gefolgt von einem zweiten Halbzyklus der Aufladung.

Bei dem oben bereits angesprochenen Betrieb, z.B. in einem Kraftfahrzeug, wird der einzelne Teilzyklus der Entladung nicht unbedingt von einer Aufladung mit entsprechender Höhe gefolgt, sondern es kann zu sehr stark variierenden Lade- und Entladezyklen kommen. Gemäß der hier Beschriebenen Ausgestaltung der Erfindung betrachtet man nun jeden der Teilzyklen und die mit ihm verbundene Lade- bzw. Entladetiefe einzeln und ermittelt anhand der Alterungskennlinie für jeden einzelnen Teilzyklus einen Alterungskennwert. Durch eine einfache Summenbildung aus diesen Alterungskennwerten kann damit auch bei einem derartig komplexen Betrieb einer Batterie die Alterung sehr einfach, schnell und effektiv ermittelt werden.

Neben den Lade- und Entladevorgängen der Batterie, welche die Lebensdauer vorwiegend beeinflussen, können sehr einfach auch weitere Faktoren, welche ebenfalls einen gewissen, jedoch deutlich kleineren Einfluss auf die Lebensdauer haben, berücksichtigt werden. Diese Faktoren können einfach zu ermittelnde, z.B. zu messende Faktoren ermittelt und durch einen einfachen Gewichtungsfaktor, welcher mit dem Alterungskennwert verrechnet wird, berücksichtigt werden. So kann beispielsweise für jeden einzelnen der ermittelten Alterungskennwerte, bevor dieser der Summenbildung zugeführt wird, ein derartiger, im allgemeinen multiplikativer Gewichtungsfaktor mit berücksichtigt, also mit dem Alterungskennwert multipliziert werden.

Als derartiger Gewichtungsfaktor kann beispielsweise die Betriebs- bzw. Umgebungstemperatur der Batterie oder auch Größe und Richtung des Lade- bzw. Entladestroms genannt werden. Selbstverständlich kann nicht nur ein einzelner Gewichtungsfaktor Berücksichtigung finden, sondern es können auch mehrere derartige Gewichtungsfaktoren mit dem jeweiligen Alterungskennwert verrechnet werden.

In einer weiteren sehr günstigen Ausführungsform des erfindungsgemäßen Verfahren werden nur Lade- bzw. Entladezyklen berücksichtigt, welche einen Kapazitätsdurchsatz haben, welcher oberhalb eines vorgegebenen Limits liegt.

Dies bedeutet, dass Ladungen unterhalb dieses vorgegebenen Limits, ebenso wie Entladungen unterhalb dieses vorgegebenen Limits, nicht berücksichtigt werden. Sinnvollerweise wird ein derartiges Limit so angesetzt, dass sowohl die Ladung als auch die Entladung der Batterie mit einer Kapazität unterhalb dieses Limits ausschließlich aus deren Doppelschichtkapazität erfolgt, so dass mit derartigen Ladevorgängen keine Beteiligung der aktiven Masse der Batterie und damit keine chemische Umsetzung derselben verbunden ist. Üblicherweise liegen bei den eingangs beschriebenen Batterietypen die Lade- bzw. Entladetiefen, welche in den Bereich der Doppelschichtkapazität fallen, in einer Größenordnung von sehr viel weniger als 1 % der maximal möglichen Ladung bzw. Entladung, also der Batteriekapazität.

Eine besonders günstige Verwendung des erfindungsgemäßen Verfahrens liegt aufgrund der, auch bei einer komplexen Betriebsstrategie der Batterie, sehr einfachen und effektiven Bestimmung der Alterung sicherlich im Bereich von hinsichtlich der Ladung und Entladung sehr unregelmäßig betriebenen Batteriesystemen, wie sie beispielsweise als Batteriesysteme in Kraftfahrzeugen Verwendung finden. Dabei kann das Verfahren sowohl bei Batterien für Traktions- bzw. Antriebszwecke als auch bei Batterien zur Versorgung von elektrischen Hilfskomponenten, wie z.B. Navigationssysteme, Fahrzeugelektronik und dergleichen, eingesetzt werden. Selbstverständlich ist der Einsatz auch bei Batterien denkbar, welche die elektrische Versorgung von Hilfseinrichtungen und Traktions- bzw. Antriebseinrichtungen gleichzeitig bewältigen.

Weitere vorteilhafte Ausgestaltungen der Erfindung ergeben sich aus den restlichen Unteransprüchen und aus den anhand der Figuren nachfolgend dargestellten Ausführungsbeispielen.

Kurzbeschreibung der Figuren

Dabei zeigen die nachfolgenden Figuren prinzipmäßig angedeutete Kennlinien, wie sie beispielsweise bei der Verwendung von Bleibatterien ermittelt werden können. Im einzelnen zeigt:

Fig. 1 einen exemplarischen Zusammenhang zwischen der Zyklenlebensdauer (N) und der Entladetiefe (DOD) einer Bleibatterie;

Fig. 2 eine beispielhafte Alterungskennlinie dieser Batterie; und

Fig. 3 ein Diagramm mit einem Beispiel für eine Batterie am Ende ihrer Lebensdauer, wobei die Anteile von einzelnen Teilzyklen hinsichtlich der Alterung und deren Anzahl dargestellt ist.

Beschreibung der bevorzugten Ausführungsbeispiele

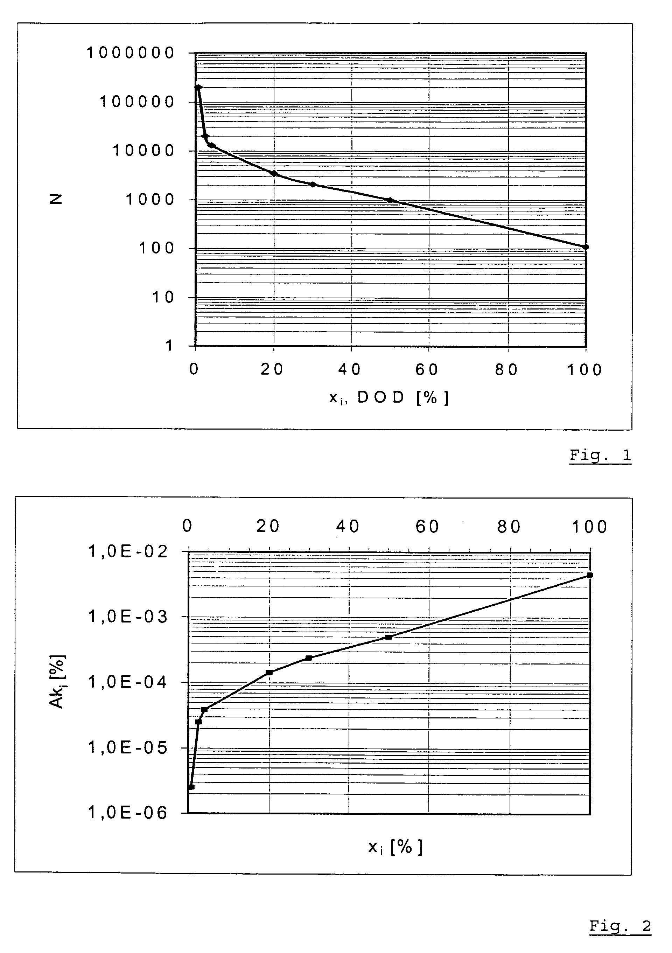

Das erfindungsgemäße Verfahren soll nachfolgend am Beispiel einer Bleibatterie allgemein erläutert werden. Dazu zeigt Fig. 1 einen annähernd halb logarithmischen Zusammenhang zwischen der Entladetiefe (DOD) und der Zyklenlebensdauer (N) dargestellt. Eine Batterie, wie sie hier dargestellt ist, besitzt beispielsweise bei einer Entladetiefe von 100 % eine Zyklenlebensdauer von ca. 100 Zyklen. Dagegen besitzt dieselbe Batterie bei einer Entladetiefe von lediglich 1 % eine Zyklenlebensdauer von ca. 30 000 Zyklen.

Des weiteren ist aus der Abbildung in Fig. 1 ersichtlich, dass die Gesamtlebensdauer der Batterie bei unterschiedlichen Entladetiefen nach einer unterschiedlichen Anzahl von Zyklen erreicht ist. Dies bedeutet, dass also zu jeder Entladetiefe eine Zyklenzahl existiert, welche äquivalent zur Lebensdauer der Batterie ist. Im Grunde geht man nun davon aus, dass ein Zyklus jeweils aus einem ersten Halbzyklus besteht, welcher aus einer Entladung um $x_{dis}$, gefolgt von einer Aufladung um $x_{cha}$ besteht. Am Ende des Zyklus wäre somit jeweils der gleiche Ladezustand erreicht, welcher zu Beginn des Zyklus vorlag. Bei einer realistischen Berechnung muss zusätzlich berücksichtigt werden, dass die Ladung der Batterie nicht frei von Verlusten erfolgt, so dass sich letztendlich die zu ladende Kapazität $x_{cha}$ aus dem Produkt der entladenen Kapazität $x_{dis}$ und dem Ladefaktor $L_F$ ergibt.

$$x_{Cha} = L_F \cdot x_{Dis} \qquad \text{Gleichung (1)}$$

In der Praxis liegen jedoch häufig sehr unterschiedliche Lade- und Entladezyklen vor, da - insbesondere bei einer Anwendung in Kraftfahrzeugen - in der Regel keine regelmäßigen Zyklen fester Entladetiefe durchlaufen werden, und da zudem die Batterie üblicherweise nicht immer vollständig aufgeladen wird. Für diesen komplexen jedoch praxisnahen Betrieb, bei dem variable Zyklen auftreten, muss also eine andere Definition für die Zyklen erfolgen. Die oben erläuterte Gleichung (1) gilt für diesen komplexen Batteriebetrieb nicht mehr, sondern für die einzelnen Ladeund Entladeschritte (mit Index i) gilt somit:

$$x_{i,Cha} \neq L_F \cdot x_{i,Dis} \qquad \text{Gleichung (2)}$$

Aufgrund dieser Gegebenheiten werden bei dem hier eingesetzten Verfahren die Entlade- und Ladezyklen als Teilzyklen einzeln gezählt und dementsprechend auch einzeln bei den weiteren Berechnungen bzw. Auswertungen berücksichtigt.

Aus dem eingangs bereits erläuterten Lebensdauerdiagramm der Fig. 1 lassen sich für jeden Wert der prozentualen Entladetiefe $x_i$ eine entsprechende Anzahl von Zyklen $y_i$ der jeweiligen Zyklenlebensdauer N ablesen. Aus diesen Wertepaaren lässt sich dann eine Alterungskennlinie für Halbzyklen berechnen, welche die Wertepaare $x_i$ und $z_i$ enthält. Diese werden dabei wie folgt bestimmt:

$$x_i \equiv x_i \qquad \text{Gleichung (3a)}$$

$$Z_i = 2 \cdot y_i \qquad \text{Gleichung (3b)}$$

Damit können dann die Alterungskennwerte $Ak_i$ für die Teilzyklen mit unterschiedlicher Lade- bzw. Entladetiefe berechnet werden:

$$Ak_i = \frac{100\%}{z_i} \qquad \text{Gleichung (4)}$$

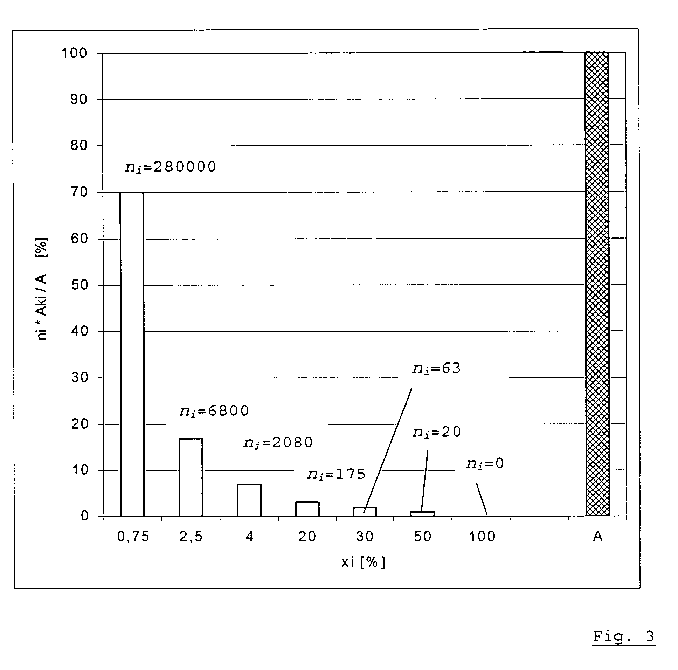

Diese Alterungskennlinie, welche sich dann als Zusammenhang zwischen der Lade- bzw. Entladetiefe $x_i$ in [%] und dem Alterungskennwert $Ak_i$ in [%] ergibt, ist in dem Diagramm der Fig. 2 wiederum halblogarithmisch aufgetragen.

Der Vorgang des Ladens bzw. Entladens und der dazugehörigen Tiefe lässt sich nun in an sich bekannter Weise mit einer einfachen Sensorik an der Batterie ermitteln. Für jeden der Teilzyklen $z_i$ ergibt sich nun aus seiner Lade- bzw. Entladetiefe $x_i$ anhand der Alterungskennlinie in dem Diagramm gemäß Fig. 2 ein entsprechender Alterungskennwert $Ak_i$, welcher für genau diesen Teilzyklus $z_i$ charakteristisch ist.

Anhand einer einfachen fortlaufenden Aufsummierung dieser Alterungskennwerte $Ak_i$ bzw. der einzelnen Anzahlen $n_i$ aller aufgetretenen Alterungskennwerte $Ak_i$ kann dann die Alterung A der Batterie im Betrieb prozentual ermittelt werden. Diese Alterung A ergibt sich dabei durch folgende Formel:

$$A = \sum_i n_i \cdot Ak_i \qquad \text{Gleichung (5)}$$

Dabei stellt $n_i$ die Anzahl der aufgetretenen Teilzyklen $z_i$ mit ihrer jeweils korrespondierenden Lade- bzw. Entladetiefe $x_i$ dar.

Die über die Summenbildung ermittelte Alterung A ist so zu verstehen, dass eine Alterung von A = 0 % einer neuwertigen Batterie gleichzusetzen ist, während eine Alterung von A = 100 % eine bereits vollständig verbrauchte Batterie bedeutet. Die Alterung A gibt also die bereits verbrauchte Lebensdauer der Batterie in Prozent an. Sie eignet sich damit direkt zur Anzeige der Alterung A, welche der bereits verbrauchten Lebensdauer der Batterie gleichzusetzen ist, oder nach einer einfachen Subtraktion von 100 % auch zur Anzeige der verbleibenden Restlebensdauer A', für welche dann gilt: A' = 100 % - A.

Ein entsprechendes Beispiel für eine derartige Berechnung ist durch die in Fig. 3 dargestellte Abbildung gegeben. Bei dem in Fig. 3 dargestellten Beispiel ist die Batterie bereits vollständig verbraucht, wie sich anhand der rechts dargestellten Säule der Alterung A, welche den Wert von 100 % erreicht hat, erkennen lässt. Die weiteren Säulen repräsentieren die Summen (über $n_i$) der einzelnen Teilzyklen $z_i$ bzw. die mit ihnen korrespondierenden Alterungskennwerte $Ak_i$ mit ihren jeweiligen Lade- bzw. Entladetiefen $x_i$, wobei die Höhe des jeweils korrespondierenden Balkens den prozentualen Anteil an der Alterung A angibt. In dem hier gewählten Beispiel kam es zu einer Anzahl von $n_i$ = 280 000 Teilzyklen der Lade- bzw. Entladetiefe $x_i$ = 0,75 %. Dies entspricht einem Anteil von 70 % Alterung A an der insgesamt aufgetretenen Alterung A. Der nächste Balken zeigt eine Anzahl $n_i$ = 6 800 Teilzyklen bei der Lade- bzw. Entladetiefe $x_i$ = 2,5 %, welcher wiederum einen Anteil von 17 % der Alterung A stellt. Die weiteren Balken ergeben sich bei den weiteren Lade- bzw. Entladetiefen $x_i$ = 4; 20; 30; 50; 100 % jeweils analog.

Zusätzlich zu dieser vergleichsweise einfachen Ausführungsform, welche die für die Alterung einer Batterie hauptsächlich relevanten Bestandteile der Ladung und Entladung bei den entsprechenden Lade- und Entladetiefen $x_i$ berücksichtigt, kann außerdem eine Optimierung des Verfahrens erfolgen, indem bei der Berechnung weitere Feinheiten einfließen.

Eine dieser Feinheiten kann beispielsweise sein, dass Kapazitätshübe bei der Ladung bzw. Entladung der Batterie, welche unter einem batteriespezifisch zu definierenden Schwellenwert $x_{min}(DOD)$ liegen, nicht als Teilzyklen gezählt werden. Der Schwellenwert $x_{min}(DOD)$ ist dabei so zu wählen, dass bei der Ladung bzw. Entladung der Batterie um einen Kapazitätswert, welcher kleiner diesem Schwellenwert $x_{min}(DOD)$ ist, keine Volumenarbeit der aktiven Massen in der Batterie stattfindet. Die eingeladene bzw. entnommene Ladung wird in der Batterie lediglich durch ein Umladen der Doppelschichtkapazität bereitgestellt. Da dieses Umladen der Doppelschichtkapazität sich nicht auf die Lebensdauer bzw. Alterung $A$ der Batterie auswirkt, sollte auf eine Berücksichtigung von Lade- bzw. Entladevorgängen mit einer Kapazität kleiner $x_{min}(DOD)$ bei der Betrachtung zur Alterung $A$ verzichtet werden. Diese Teilzyklen werden also nicht verarbeitet, so dass hier keine Alterungskennwerte ermittelt und der Summenbildung gemäß Gleichung (5) zugeführt werden.

Eine weitere derartige Einflussgröße für die Optimierung der Alterungsüberwachung stellt die Betriebstemperatur $T$ der Batterie dar. Die Berechnung der Alterung $A$ der Batterie lässt sich weiter verfeinern, wenn zusätzlich temperaturabhängige Gewichtungsfaktoren $f_{i,T}$ berücksichtigt werden. Die Berechnung der Alterung A ergibt sich dann gemäß der nachfolgenden Gleichung:

$$A = \sum_T \sum_i n_{i,T} \cdot Ak_i \cdot f_{i,T} \qquad \text{Gleichung (6)}$$

In vergleichbarer Weise zu diesen Gewichtungsfaktoren $f_{i,T}$ aufgrund der Betriebstemperatur der Batterie können weitere Gewichtungsfaktoren Verwendung finden. Besonders günstig und sinnvoll ist es dabei, den Einfluss der Stromstärke über einen weiteren, gegebenenfalls zusätzlichen Gewichtungsfaktor $f_{i,I}$ zu berücksichtigen. Die Berechnung der Alterung A ergibt sich dann wie folgt:

$$A = \sum_I \sum_T \sum_i n_{i,T,I} \cdot Ak_i \cdot f_{i,T} \cdot f_{i,I} \qquad \text{Gleichung (7)}$$

Diese erläuterten drei Möglichkeiten der Verfeinerung der Berechnung der Alterung über die Gewichtungsfaktoren $f_{i,T}$ und $f_{i,I}$ sowie über die Aktivierung der Alterungskennwerte $Ak_i$ nur dann, wenn die Teilzyklen eine Ladungbzw. Entladung mit einer Kapazität größer dem Schwellenwert $x_{min}(DOD)$ umfassen, können sowohl gemeinsam als auch einzeln oder in allen denkbaren Kombinationen untereinander Verwendung finden, um die grundlegende Berechnung der Alterung $A$ in der hier dargestellten Art über die Summe der Alterungskennwerte $Ak_i$ zu bestimmen.

Für die Abbildung der entsprechenden Abhängigkeiten, also der Alterungskennlinie, können dabei sowohl kontinuierliche Funktionen der Gewichtungsfaktoren bzw. Alterungskennlinie Verwendung finden. Die Abhängigkeiten könnten jedoch auch in Form von approximierten Intervallen dargestellt und verwendet werden, wobei diese dann mit jeweils an die erforderliche Genauigkeit der Berechnung der Alterung $A$ und an den jeweiligen Batterietyp angepassten Klassenbreiten angelegt sein können.

Insbesondere für die Implementierung in Steuergeräte, beispielsweise in die komplexen Steuergeräte eines Kraftfahrzeugs, wäre die zweite Ausgestaltungsvariante mit den approximierten Intervallen angepasster Klassenbreite von besonderer Bedeutung, da diese eine sehr schnelle Verarbeitung der entsprechenden Werte bei entsprechend wenig Bedarf an Rechen- und Speicherkapazität in dem Steuergerät erlaubt.

Die bisher vergleichsweise allgemein erläuterten Zusammenhänge sollen nachfolgend anhand von zwei konkreten Zahlenbeispielen exemplarisch dargestellt werden.

Zahlenbeispiel 1

Nachfolgend ist die Berechung der Alterung $A$ einer Bleibatterie anhand eines Zahlenbeispiels detailliert beschrieben.

Vorgeben ist dabei die Zyklenlebensdauerkurve analog dem Diagramm in Fig. 1 für eine Bleibatterie mit den Wertepaaren $(x_i, y_i)$. Diese Wertepaare finden sich dabei in den Spalten 1 und 2 der nachfolgend dargestellten Tabelle 1. Aus den Zyklen $y_i$ in Spalte 2 der Tabelle 1 werden gemäß dem Zusammenhang in Gleichung (3) die Teilzyklen $z_i$ ermittelt. Aus diesen Teilzyklen $z_i$ kann dann der Alterungskennwert $Ak_i$, wie er in Spalte 4 der Tabelle 1 dargestellt ist, gemäß Gleichung (4) berechnet werden.

### Tabelle 1

| 1 | 2 | 3 | 4 |
|---|---|---|---|
| $x_i$ | $y_i$ | $z_i$ | $Ak_i$ |
| (DOD) | (Zyklen) | (Teilzyklen) | (Alterungskennwert) |
| 100 | 120 | 240 | 0,416667 |
| 50 | 1200 | 2400 | 0,041667 |
| 30 | 2000 | 4000 | 0,025000 |
| 20 | 3500 | 7000 | 0,014286 |
| 10 | 12000 | 24000 | 0,004167 |
| 5 | 20000 | 40000 | 0,002500 |
| 3 | 50000 | 100000 | 0,001000 |

### Tabelle 2

| 1 | 2 | 3 |
|---|---|---|
| $x_i$ | $n_i$ | $A_i$ in [%] |
| (DOD) | (Anzahl der Teilzyklen) | (Alterungsanteil) |
| 100 | 7 | 2,92 |
| 50 | 11 | 0,46 |
| 30 | 63 | 1,58 |
| 20 | 168 | 2,40 |
| 10 | 805 | 3,35 |
| 5 | 5993 | 14,98 |
| 3 | 69201 | 69,20 |
| **Alterung A in [%]** | | **94,89** |

In der Tabelle 2 ist in der Spalte 2 die bei jeder Lade- bzw. Entladetiefe $x_i$ real abgelaufene Anzahl $n_i$ an Teilzyklen dargestellt. Zusammen mit den Alterungskennwerten $Ak_i$ für die jeweilige Lade- bzw. Entladetiefe $x_i$ aus Tabelle 1 können so gemäß des Zusammenhangs in Gleichung (5) die Anteile $A_i$ an der Alterung $A$ berechnet werden. Diese sind in Spalte 3 der Tabelle 2 dargestellt. Die Summe dieser Anteile $A_i$ ergibt dann die Alterung $A$ der Batterie, welche bei dem hier ausgeführten Zahlenbeispiel $A$ = 94,89 % beträgt.

Bei der hier exemplarisch dargestellten Berechnung der Alterung $A$, wurde zur Verdeutlichung des Sachverhalts eine bewusst einfaches Beispiel ohne die Berücksichtigung von Gewichtungsfaktoren $f_i$ gewählt.

### Zahlenbeispiel 2

Nachfolgend ist exemplarisch die Berechung der Alterung $A$ einer Nickelmetallhydridbatterie anhand eines weiteren detaillierter ausgeführten Zahlenbeispiels beschrieben. Dabei wurden dieses Mal auch die Gewichtungsfaktoren $f_i$ in die exemplarische Berechnung mit einbezogen, ohne dass dies bedeuten soll, das die Gewichtungsfaktoren *f*$_i$ auf eine Anwendung bei Nickelmetallhydridbatterien eingeschränkt sind.

Das erwähnte Zahlenbeispiel 2 soll nun analog zum Zahlenbeispiel 1 dargestellt werden. In Tabelle 3 sind, analog zu der oben bereits erläuterten Tabelle 1 die entsprechenden Werte für $x_i$, $y_i$, $z_i$ und $Ak_i$ aufgelistet. Sie ergeben sich analog zu den Werten in Tabelle 1 anhand der Gleichungen (3) und (4).

### Tabelle 3

| 1 | 2 | 3 | 4 |
|---|---|---|---|
| $x_i$ | $y_i$ | $z_i$ | $Ak_i$ |
| (DOD) | (Zyklen) | (Teilzyklen) | (Alterungskennwert) |
| 100 | 2493 | 4986 | 0,020056 |
| 50 | 29191 | 58382 | 0,001713 |
| 30 | 78090 | 156180 | 0,000640 |
| 25 | 99869 | 199738 | 0,000501 |
| 12 | 189324 | 378648 | 0,000264 |
| 5 | 267164 | 534328 | 0,000187 |
| 3 | 294789 | 589578 | 0,000170 |

Zur Abbildung des Einflusses der Temperatur dient die nachfolgenden Tabelle 4, in welcher die entsprechenden Gewichtungsfaktoren $f_{i,T}$ in den Spalten 2 bis 5 der Tabelle 4 für ausgewählte Temperaturen T als Funktion der Entladetiefe $x_i$ dargestellt sind.

### Tabelle 4

| 1 | 2 | 3 | 4 | 5 |
|---|---|---|---|---|
| $x_i$ | $f_{i,-25°C}$ | $f_{i,0°C}$ | $f_{i,25°C}$ | $f_{i,45°C}$ |
| (DOD) | (Faktor) | (Faktor) | (Faktor) | (Faktor) |
| 100 | 0,795 | 0,904 | 1,000 | 4,695 |
| 50 | 0,816 | 0,915 | 1,000 | 4,505 |
| 30 | 0,844 | 0,930 | 1,000 | 4,428 |
| 25 | 0,858 | 0,937 | 1,000 | 4,409 |
| 12 | 0,949 | 0,985 | 1,000 | 4,360 |
| 5 | 1,194 | 1,113 | 1,000 | 4,333 |
| 3 | 1,474 | 1,260 | 1,000 | 4,325 |

**Tabelle 5**

| 1 $x_i$ | 2 $n_{i,-25°C}$ | 3 $n_{i,0°C}$ | 4 $n_{i,25°C}$ | 5 $n_{i,45°C}$ | 6 $A_i$ [%] |
|---|---|---|---|---|---|
| (DOD) | (Anzahl) | (Anzahl) | (Anzahl) | (Anzahl) | (Alterungsanteil) |
| 100 | 0 | 0 | 3 | 1 | 0,15 |
| 50 | 1 | 0 | 1 | 0 | 0,00 |
| 30 | 6 | 1 | 1 | 1 | 0,01 |
| 25 | 0 | 113 | 523 | 204 | 0,77 |
| 12 | 9 | 793 | 1899 | 508 | 1,29 |
| 5 | 13 | 13089 | 23904 | 10687 | 15,87 |
| 3 | 383 | 23056 | 78053 | 31068 | 41,05 |

Alterung A in [%]                    59,14

In der oben dargestellten Tabelle 5 sind dann wieder, analog zu der Darstellung der Anzahl $n_i$ in Tabelle 2 des Zahlenbeispiels 1 die Anzahlen $n_{i,T}$ der Teilzyklen $z_i$ für die unterschiedlichen in Tabelle 4 bereits berücksichtigten Temperaturen $T$ angegeben. Die Anteile $A_i$ an der Alterung $A$ errechnen sich dann in dem hier dargestellten Zahlenbeispiel anhand der Gleichung (6). Sie sind in Spalte 6 der Tabelle 5 dargestellt. Es errechnet sich somit eine Alterungszustand von $A$ = 59,14 %, welcher entsprechend des Eingangs erläuterten Prinzips, unter Berücksichtigung der von Lade- bzw. Entladetiefe $x_i$ und Temperatur $T$ abhängigen Gewichtungsfaktoren $f_{i,T}$, ergibt.

In gleicher Weise kann über einen weiteren Gewichtungsfaktor $f_{i,I}$ auch die Stromabhängigkeit in die Berechnung der Alterung $A$ der Batterie integriert werden. Es müsste dann eine weitere Tabelle verwendet werden, welche die Gewichtungsfaktoren $f_{i,I}$ als Funktion der Temperatur $T$ und des Stroms $I$ enthält. Tabelle 5 müsste dann um eine Dimension erweitert werden, so dass sich in einer Richtung die Lade- bzw. Entladetiefe $x_i$, in der zweiten Richtung die Temperatur $T$ und als neue Dimension die Stromstärke $I$ dargestellt werden kann.

Für die Anwendung in Steuergeräten ist dies jedoch unproblematisch, da die Alterung $A$ der Batterie nach Abschluss eines Teilzyklus sofort durch aufsummieren des sich für den Teilzyklus ergebenden Anteils $A_i$ der Alterung $A$ aktualisiert wird und da somit keine großen Matrizen für die Teilzyklenzahlen zu speichern sind.

**Patentansprüche**

1. Verfahren zur Ermittlung der Alterung einer Batterie, wobei Lade- und Entladezyklen der Batterie nach Anzahl und Tiefe der Ladung/Entladung erfasst werden, wobei für jeden der Lade- und Entladezyklen ein Alterungskennwert anhand einer für den jeweiligen Batterietyp charakteristischen Alterungskennlinie ermittelt wird, und wobei einzelnen Alterungskennwerte zur Alterung der Batterie aufsummiert werden.

2. Verfahren nach Anspruch 1,
   **dadurch gekennzeichnet,**
   **dass** jeder Teilzyklus der Ladung und jeder Teilzyklus der Entladung getrennt erfasst wird, wobei für jeden der Teilzyklen der Alterungskennwert ermittelt wird, und wobei die Alterungskennwerte für alle Teilzyklen gemeinsam aufsummiert werden.

3. Verfahren nach Anspruch 1,
   **dadurch gekennzeichnet,**
   **dass** die Abhängigkeit der Alterungskennwerte von der Lade-/Entladetiefe durch die Alterungskennlinie als kontinuierliche Funktion für den jeweiligen Batterietyp fest vorgegeben wird.

4. Verfahren nach Anspruch 1,
   **dadurch gekennzeichnet,**
   **dass** die Abhängigkeit der Alterungskennwerte von der Lade-/Entladetiefe durch die Alterungskennlinie aus approximierten Intervallen mit an den jeweiligen Batterietyp angepasster Klassenbreite für den jeweiligen Batterietyp fest vorgegeben wird.

5. Verfahren nach Anspruch 3 oder 4,
   **dadurch gekennzeichnet,**
   **dass** die Alterungskennlinie zumindest in einzelnen Abschnitten durch Gewichtungsfaktoren an aktuell im Bereich der Batterie vorliegenden Gegebenheiten angepasst wird.

6. Verfahren nach Anspruch 5,
   **dadurch gekennzeichnet,**
   **dass** die Gewichtungsfaktoren von der Temperatur abhängig sind.

7. Verfahren nach Anspruch 5,
   **dadurch gekennzeichnet,**
   **dass** die Gewichtungsfaktoren von der Richtung und Stärke des Lade/Entladestroms abhängig sind.

8. Verfahren nach Anspruch 6,
   **dadurch gekennzeichnet,**
   **dass** die Gewichtungsfaktoren von der Richtung und Stärke des Lade/Entladestroms abhängig sind.

9. Verfahren nach Anspruch 2,
   **dadurch gekennzeichnet,**
   **dass** die Abhängigkeit der Alterungskennwerte von der Lade-/Entladetiefe durch die Alterungskennlinie als kontinuierliche Funktion für den jeweiligen Batterietyp fest vorgegeben wird.

10. Verfahren nach Anspruch 2,
    **dadurch gekennzeichnet,**
    **dass** die Abhängigkeit der Alterungskennwerte von der Lade-/Entladetiefe durch die Alterungskennlinie aus approximierten Intervallen mit an den jeweiligen Batterietyp angepasster Klassenbreite für den jeweiligen Batterietyp fest vorgegeben wird.

11. Verfahren nach Anspruch 9 oder 10,
    **dadurch gekennzeichnet,**
    **dass** die Alterungskennlinie zumindest in einzelnen Abschnitten durch Gewichtungsfaktoren an aktuell im Bereich der Batterie vorliegenden Gegebenheiten angepasst wird.

12. Verfahren nach Anspruch 11,
    **dadurch gekennzeichnet,**
    **dass** die Gewichtungsfaktoren von der Temperatur abhängig sind.

13. Verfahren nach Anspruch 11,
    **dadurch gekennzeichnet,**
    **dass** die Gewichtungsfaktoren von der Richtung und Stärke des Lade/Entladestroms abhängig sind.

14. Verfahren nach Anspruch 12,
    **dadurch gekennzeichnet,**
    **dass** die Gewichtungsfaktoren von der Richtung und Stärke des Lade/Entladestroms abhängig sind.

15. Verfahren nach Anspruch 1 oder 2,
    **dadurch gekennzeichnet,**
    **dass** Lade-/Entladezyklen mit einem Kapazitätsdurchsatz unterhalb eines vorgegebnen Limits nicht berücksichtigt werden.

16. Verwendung des Verfahrens nach Anspruch 1 oder 2, für eine Batterie, welche in einem Kraftfahrzeug für die elektrische Energieversorgung von elektronischen Hilfskomponenten eingesetzt wird.

17. Verwendung des Verfahrens nach Anspruch 1 oder 2, für eine Batterie, welche in einem Kraftfahrzeug für die elektrische Energieversorgung von Antriebskomponenten eingesetzt wird.

**18.** Verfahren nach Anspruch 3 oder 4,
**dadurch gekennzeichnet,**
**dass** Lade-/Entladezyklen mit einem Kapazitätsdurchsatz unterhalb eines vorgegebnen Limits nicht berücksichtigt werden.

**19.** Verwendung des Verfahrens nach Anspruch 3 oder 4, für eine Batterie, welche in einem Kraftfahrzeug für die elektrische Energieversorgung von elektronischen Hilfskomponenten eingesetzt wird.

**20.** Verwendung des Verfahrens nach Anspruch 3 oder 4, für eine Batterie, welche in einem Kraftfahrzeug für die elektrische Energieversorgung von Antriebskomponenten eingesetzt wird.

Fig. 1

Fig. 2

12

Fig. 3